(19) **Europäisches Patentamt / European Patent Office / Office européen des brevets**

(11) **EP 2 891 216 B1**

(12) **EUROPEAN PATENT SPECIFICATION**

(45) Date of publication and mention of the grant of the patent:
**01.04.2020 Bulletin 2020/14**

(21) Application number: **13750280.3**

(22) Date of filing: **06.08.2013**

(51) Int Cl.:
*H02H 1/04* *(2006.01)*        *H02H 7/045* *(2006.01)*
*G01R 19/10* *(2006.01)*

(86) International application number:
**PCT/EP2013/066451**

(87) International publication number:
**WO 2014/032915 (06.03.2014 Gazette 2014/10)**

(54) **METHOD AND DEVICE FOR DETECTING MAGNETIZING INRUSH CURRENT OF A TRANSFORMER**

VERFAHREN UND VORRICHTUNG ZUR ERKENNUNG EINES MAGNETISIERUNGSEINSCHALTSTROMS BEI EINEM TRANSFORMATOR

PROCÉDÉ ET DISPOSITIF DE DÉTECTION DE COURANT D'APPEL MAGNÉTISANT D'UN TRANSFORMATEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.08.2012 CN 201210320886**

(43) Date of publication of application:
**08.07.2015 Bulletin 2015/28**

(73) Proprietor: **Siemens Aktiengesellschaft**
**80333 München (DE)**

(72) Inventors:
- **CHEN, Wei**
  **Wuhan 430074 (CN)**
- **QIN, Lei Ming**
  **Nanjing 211100 (CN)**
- **CHEN, Shu De**
  **Wuhan 430074 (CN)**

- **GAO, Di Jun**
  **Nanjing 210004 (CN)**
- **LI, Jin Hui**
  **Nanjing 210017 (CN)**
- **RAO, Chun**
  **Hubei**
  **Wuhan 437300 (CN)**
- **YANG, Min**
  **211100 Nanjin (CN)**

(74) Representative: **Isarpatent**
**Patent- und Rechtsanwälte Behnisch Barth Charles**
**Hassa Peckmann & Partner mbB**
**Friedrichstrasse 31**
**80801 München (DE)**

(56) References cited:
**US-A- 3 657 605**

Printed by Jouve, 75001 PARIS (FR)

## Description

## Technical field

The present invention relates to transformer protection technology in general, and in particular to a method and device for detecting the magnetizing inrush current which occurs when a transformer is switched on with no load, and a magnetizing inrush current restraint method and device.

## Background art

In an electrical system, a large transient current will occur when a transformer is switched on with no load, for instance 6 - 8 times the rated current of the transformer. This large transient current which occurs when a transformer is switched on with no load is what is known as "magnetizing inrush current" in the art. As a result, there is a strong likelihood that the occurrence of a magnetizing inrush current when the transformer is switched on with no load will erroneously trigger the differential protection action of the transformer, so that the transformer automatically trips in the instant after it is switched on.

The main reason for the occurrence of "magnetizing inrush current" is that when a transformer is switched on with no load, the iron core thereof rapidly reaches severe saturation while the magnetizing impedance is greatly reduced, the result being a magnetizing inrush current of large amplitude. A characteristic of magnetizing inrush current is the very large value of the current surge, which can reach 6 - 8 times or even 10 times the rated current of the transformer. Furthermore, a large part of the magnetizing inrush current is made up of a DC component and high-order harmonic components, the waveforms thereof being mostly biased towards one side of the time axis. Moreover, the waveform of the magnetizing inrush current may be intermittent. In general, the magnetizing inrush current falls to a value typically no more than 0.25 - 0.5 of the rated current within 0.5 - 1s of occurring, but in the case of large-capacity transformers, the total attenuation time thereof may be as long as several seconds.

To avoid erroneous activation of transformer differential protection as a result of the magnetizing inrush current, the main transformer protection configured in current electrical systems generally includes differential protection based on restraint of the second harmonic associated with the magnetizing inrush current. In response to the requirement for the main protection to have a dual function, many factories not only configure differential protection based on second harmonic restraint, but also make use of waveform characteristics to configure differential protection in which inrush current restraint is achieved on the basis of the interruption angle principle or waveform symmetry principle, etc. When the interruption angle principle is used in microcomputer protection, the high requirements it places on hardware make the implementation method rather difficult. The criterion for inrush current restraint based on the waveform symmetry principle has a simple structure and places lower requirements on hardware, and is therefore more suited to being used as the basis for main transformer protection which is different from second harmonic restraint and works in conjunction with differential protection.

Chinese patent application CN1182297A has disclosed a method for distinguishing magnetizing inrush current based on waveform symmetry. The method compares the values of two successive half-waves at sampling points to determine whether the current waveform is symmetric. Symmetry indicates a fault current; asymmetry indicates a magnetizing inrush current.

US 3,657,605 A discloses a method for detecting magnetizing inrush current for a three-phase transformer which includes analysing each phase individually for inrush current indications.

## Content of the invention

One object of the present invention is to propose a novel method and device for detecting a magnetizing inrush current in a transformer as recited in the independent claims.

According to one aspect of the present invention, a magnetizing inrush current detection method for a transformer is proposed, comprising: obtaining a current $i_x(n)$ for each AC phase of the transformer; determining whether the current $i_x(n)$ of any one of the three AC phases exceeds a predetermined current threshold; if the current $i_x(n)$ of any AC phase exceeds the predetermined current threshold, then calculating, for each AC phase, at least two factors (Ax, Bx) for waveform symmetry recognition, on the basis of the currents of that AC phase obtained within one period; for each type of factor, obtaining the maximum value of the three factors corresponding to the three AC phases, to serve as a maximum phase factor of that factor; based on the maximum phase factor obtained, using a waveform symmetry recognition algorithm to calculate a corresponding waveform symmetry parameter $k_{max}$; if the waveform symmetry parameter $k_{max}$ meets a requirement for waveform asymmetry and the current $i_x(n)$ of any AC phase exceeds a predetermined current threshold, then determining that a magnetizing inrush current has occurred. Preferably, the step of calculating at least two factors further comprises: filtering out a DC component of the sampled current $i_x(n)$, to obtain a difference value

$i'_x(n)$ of the current.

According to a preferred embodiment of the present invention, the factors used for waveform symmetry recognition comprise: a first factor (Ax), which is a function of the sum of two current difference values separated by half a period; and a second factor (Bx), which is a function of the difference between two difference current values separated by half a period. Preferably, the function used for the first factor (Ax) is the cumulative value of the modulus of said sum over half a period; the function used for the second factor (Bx) is the cumulative value of the modulus of said difference over half a period. Even more preferably, the waveform symmetry parameter $k_{max}$ is the maximum phase factor of the first factor (Ax) divided by the maximum phase factor of the second factor (Bx). The difference current value $i'_x(n)$ is found by a forward difference method.

According to another aspect of the present invention, a magnetizing inrush current restraint method for a transformer is proposed, comprising: determining by the above method whether the current flowing through the transformer at the present time is a magnetizing inrush current; if it is a magnetizing inrush current, then blocking differential protection of the transformer. According to another aspect of the present invention, a transformer protection device for realizing the above method is further proposed. The device comprises: an acquisition unit, for obtaining a current $i_x(n)$ for each AC phase flowing through the transformer; a first judgment unit, for determining whether the current $i_x(n)$ of any one of the three AC phases exceeds a predetermined current threshold; a factor calculation unit, for calculating at least two factors for waveform symmetry recognition for each AC phase, on the basis of currents $i_x(n)$ sampled within one period; a maximum value determination unit, for obtaining the maximum value of the three factors corresponding to the three AC phases for each type of factor, to serve as a maximum phase factor (Amax, Bmax) of that factor; a symmetry parameter acquisition unit, for calculating a corresponding waveform symmetry parameter $k_{max}$ according to said waveform symmetry recognition, based on the maximum phase factor obtained (Amax, Bmax); and a second judgment unit, for determining that a magnetizing inrush current has occurred if the waveform symmetry parameter $k_{max}$ meets the requirement for waveform asymmetry and the first judgment unit gives a positive result. Preferably, the factor calculation unit further comprises: a filter unit, for filtering out a DC component from the sampled current, so as to obtain a difference value of the current; and the factor calculation unit calculates the at least two factors on the basis of the difference value of the current.

Preferably, the factors used for waveform symmetry recognition comprise: a first factor, which is the cumulative sum over an entire half-cycle of the sum of two difference current values separated by half a period; and a second factor, which is the cumulative sum over an entire half-cycle of the difference between two difference current values separated by half a period. Preferably, the device further comprises a blocking unit, for blocking differential protection of the transformer when the judgment unit determines that a magnetizing inrush current has occurred.

According to another aspect of the present invention, a device for transformer protection is proposed, comprising: a microprocessor, for performing operations or processing according to commands; a memory, for storing commands which can be executed by the microprocessor, the commands being used to realize the method described when executed by the microprocessor. A computer program product, comprising: code which can be executed by a machine, the code being used to realize the method as claimed in any one of claims 1-6 when executed by the machine. A computer recording medium, comprising: a machine-recordable/readable medium on which machine-executable code is stored, the code being used to realize the method described above when executed by a machine.

Since the magnetizing inrush current detection method proposed by the present invention takes full account of the relationships among the three AC phases, more accurate inrush current recognition is achieved when this method is used. Secondly, the present invention uses a waveform symmetry algorithm based on sampled currents (preferably difference values of currents); this algorithm is able to correctly judge whether a magnetizing inrush current has occurred in a shorter time than other algorithms. Furthermore, since the present invention preferably uses currents from which DC components have been filtered out to calculate waveform symmetry factors, interference from DC components is avoided, so that the accuracy of recognition is higher. In addition, in the present invention, differential protection is blocked if the occurrence of a magnetizing inrush current is determined, and permitted otherwise; this logic can ensure reliable operation of differential protection more effectively. Moreover, using the method of the present invention enables rapid cut-off within one cycle when faults of all kinds occur. Also, when the second harmonic content of the magnetizing inrush current in a particular phase is less than 15%, a blocking flag can similarly be issued. In the method proposed by the present invention, since the existence of a fault phase causes the denominator to remain relatively high, the waveform symmetry parameter $k_{max}$ falls rapidly below a blocking constant value. When the system impedance is very high, if a single phase is grounded on the star side or an inter-phase fault occurs between two phases on the delta side, the method proposed in the present invention is still capable of operation, and so protection is still able to operate correctly. In summary, the criterion described above can act quickly and correctly when all kinds of faults occur, and a blocking flag can be reliably set in the event of a magnetizing inrush current. Thus, the present solution has improved performance in terms of recognizing inrush currents and distinguishing faults.

**Description of the accompanying drawings**

The object, characteristics, features and advantages of the present invention will be made more obvious by the following detailed description, which makes reference to the accompanying drawings.

Figs. 1A - 1C show typical waveforms of magnetizing inrush currents occurring in three AC phases A, B and C by way of example;

Fig. 2 shows a flow chart for magnetizing inrush current detection according to one embodiment of the present invention by way of example;

Fig. 3 shows a logic diagram for magnetizing inrush current restraint according to one embodiment of the present invention by way of example;

Figs. 4A - 4C show the waveform of a magnetizing inrush current, the variation of the corresponding waveform symmetry parameter and the variation of the second harmonic according to one embodiment of the present invention by way of example;

Figs. 5A - 5C show the waveform of a fault inrush current, the variation of the corresponding waveform symmetry parameter and the variation of the second harmonic according to another embodiment of the present invention by way of example;

Fig. 6 shows a block diagram of the structure of a transformer protection device according to another embodiment of the present invention by way of example.

**Particular embodiments**

Various embodiments of the present invention will be described below with reference to the accompanying drawings. The following description will facilitate understanding of the above-mentioned advantages of the present invention.

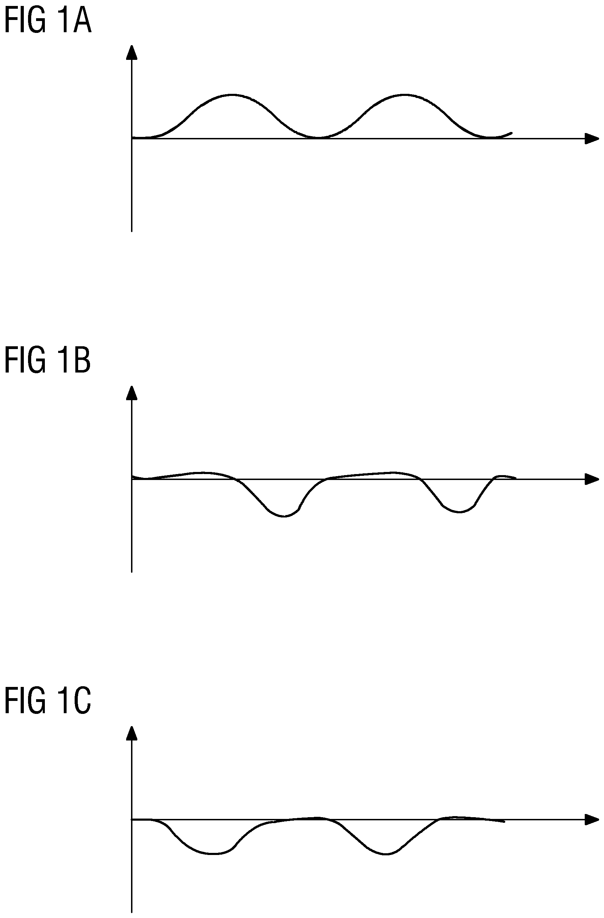

Figs. 1A - 1C show typical waveforms of magnetizing inrush currents occurring in three AC phases a, b and c of a three-phase transformer by way of example. By studying the characteristics of the magnetizing inrush current waveforms with reference to Fig. 1, it can be determined that the magnetizing inrush currents have the following characteristics.

(1) When a transformer is switched on with no load, whether an inrush current arises and the size of such an inrush current is related to the phase angle at the time of switch-on, the magnetizing inrush current being greatest for phase angles $\alpha = 0$ and $\alpha = \pi$ at switch-on.

(2) The magnetizing inrush currents in the three phases will be different, because there is a 120° phase difference between the voltages of the three phases.

(3) The magnetizing inrush current in a particular phase may no longer deviate from one side of the time axis, becoming a so-called "symmetric" inrush current. The other two phases are still asymmetric inrush currents which deviate from one side of the time axis. The value of the symmetric inrush current is comparatively small. Non-periodic attenuation components still make up a large part of the asymmetric inrush currents, but the non-periodic component in the symmetric inrush current is comparatively small.

(4) Transformer operating records show that the second harmonic may make up a comparatively small proportion of the magnetizing inrush current in one of the three phases, less than 15%.

(5) The waveforms of the magnetizing inrush currents in the three phases are still intermittent, but the interruption angles thereof are significantly reduced compared with a single-phase transformer inrush current; moreover, the interruption angle is smallest in the case of the symmetric inrush current.

(6) It can be seen from the above three diagrams that a magnetizing inrush current is generally asymmetric over 1/4 of a cycle or more.

Based on the above analysis of magnetizing inrush currents, the inventors of the present application propose a novel method for detecting a magnetizing inrush current, i.e. a maximum phase analysis method based on waveform symmetry. Overall, in view of the differences evident in the magnetizing inrush current across the three phases, the inventors of the present application point out that it is better to consider the characteristics of the currents in the three phases overall than to simply consider whether the waveform in each phase is symmetric individually. Based on this thinking, the inventors of the present application point out that during the process of estimating whether a waveform is symmetric, the maximum value of the factors corresponding to the three phases should be selected for each of the different factors (e.g. Ax and Bx) used to calculate the waveform symmetry factor k. A waveform symmetry parameter Kmax calculated by such a method can comprehensively reflect the manifestation of the magnetizing inrush current in the three phases, and thereby prevent erroneous judgments caused by testing each phase separately. Here, the waveform symmetry parameter $k_{max}$ is a parameter used to describe the asymmetry of a current waveform; a higher value of $k_{max}$ implies more marked asymmetry.

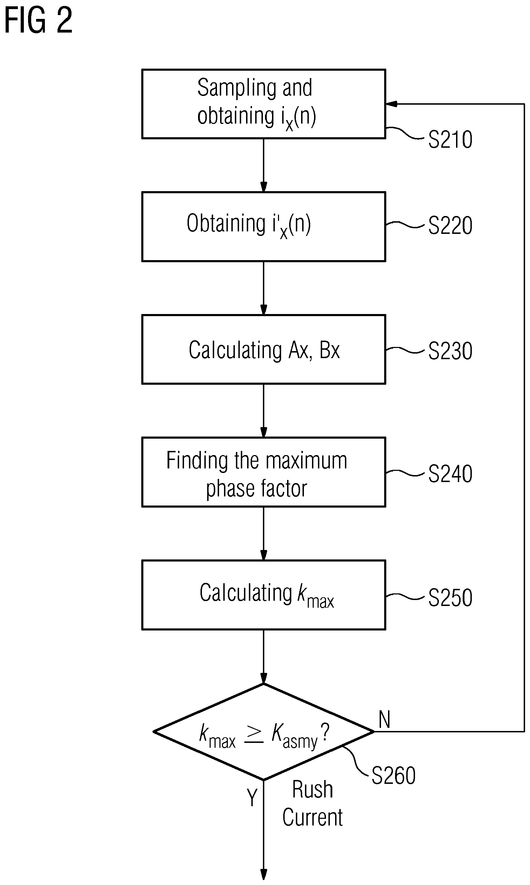

Fig. 2 shows a flow chart of a method for inrush current detection according to a preferred embodiment of the present invention by way of example.

As Fig. 2 shows, the inrush current detection method starts with step S210. In step S210, a current $i_x(n)$, where x = a, b, c, is first obtained for each AC phase of a three-phase transformer, wherein a, b and c each represent one AC phase. In step S220, preferably, the sampled difference current of each AC phase is filtered, so that a DC component is filtered out from the sampled current. Here, step S220 is optional. When the judgment conditions for waveform asymmetry are different, step S220 may be omitted. The aim of performing step S220 is to obtain the amount of change in current.

Specifically, step S220 may employ a forward difference method. For example, in one embodiment, suppose that the data window width is one period plus 1 sampling point, giving a data window width of N + 1 points, where N is the number of sampling points in each period. Therefore, the filtered difference current is the difference value of the current, and can be expressed as:

$$i_x'(n) = i_x(n) - i_x(n-1) \dots\dots\dots\dots\dots\dots\dots\dots\dots\dots\dots\dots\dots\dots(1)$$

Depending on the actual situation, if the number of sampling points in one period is sufficiently large, then the sampled value i(n) of the current at the present time minus the value at a sampling point spaced therefrom in the forward direction by one or more sampling points, such as i(n-M) where M = 2, 3..., can be chosen for the forward difference described above. In certain situations, a backward difference method may also be used.

In step S230, two factors $A_x$ and $B_x$ for waveform symmetry recognition are calculated for each AC phase a, b and c. In this embodiment, the value of the $n^{th}$ point in the current half-period in the data window is set as i'(n), while the value of the corresponding point in the previous half-period as $i_x'(n-N/2)$; then

$$A_x(n) = i_x'(n) + i_x'\left(n - \frac{N}{2}\right) \dots\dots\dots\dots\dots\dots\dots\dots\dots\dots\dots\dots\dots(2)$$

$$B_x(n) = i_x'(n) - i_x'\left(n - \frac{N}{2}\right) \dots\dots\dots\dots\dots\dots\dots\dots\dots\dots\dots\dots\dots(3)$$

$A_x(n)$ and $B_x(n)$ are factors of a waveform symmetry recognition algorithm. According to formulas (2) and (3), if the waveform is symmetric (a sine wave), then $i_x'(n) \approx -i_x'\left(n - \frac{N}{2}\right)$ hence $A_x(n) \approx 0$. At the same time, $B_x(n) \approx 2i_x'(n)$. In other words, $k = \dfrac{A_x(n)}{B_x(n)} \approx 0$ In contrast, if the waveform is not symmetric, then $k = \dfrac{A_x(n)}{B_x(n)}$ is far greater than zero. Preferably, in this embodiment, in order to make recognition more accurate, $A_x(n)$ and $B_x(n)$ must be further subjected to the following processing, to obtain:

$$A_x = \sum_{n=0}^{\frac{N}{2}-1} \left|A_x(n)\right|,$$

$$B_x = \sum_{n=0}^{\frac{N}{2}-1} \left|B_x(n)\right|,$$

$x = a, b, c$

Here, the form of $A_x$ and $B_x$ is schematic. Both the number of factors and the form they take may vary with different waveform symmetry recognition methods. For example, $A_x = \sum_{n=0}^{\frac{N}{2}-1} A_x^2(n)$ alternatively, an accumulation operation may be performed, over an entire period for instance. Alternatively, if the proportion of the differential current sample made up by a high-frequency component is taken as the basis for assessing waveform distortion, then factor $A_x$ may be replaced by the size of the high-frequency component, while the factor $B_x$ may be replaced by the size of the fundamental wave component in the differential current. In other situations, the number of factors may also be greater than two.

In step S240, for each type of factor $A_x$ and $B_x$, the maximum value of the three factors corresponding to the three AC phases is found, i.e. $Max(A_a, A_b, A_c)$ and $Max(A_a, A_b, A_c)$ are found. The maximum value obtained for each type of factor is called the maximum phase factor, e.g. $A_{max}$ or $B_{max}$.

In step S250, a wave symmetry parameter is calculated on the basis of the maximum phase factors calculated. In this embodiment,

$$k_{max} = \frac{A_{max}}{B_{max}} = \frac{Max\left\{\sum_{n=0}^{\frac{N}{2}-1}\left|A_a(n)\right|, \sum_{n=0}^{\frac{N}{2}-1}\left|A_b(n)\right|, \sum_{n=0}^{\frac{N}{2}-1}\left|A_c(n)\right|\right\}}{Max\left\{\sum_{n=0}^{\frac{N}{2}-1}\left|B_a(n)\right|, \sum_{n=0}^{\frac{N}{2}-1}\left|B_b(n)\right|, \sum_{n=0}^{\frac{N}{2}-1}\left|B_c(n)\right|\right\}} \quad\cdots\cdots(4)$$

Formula (4) merely shows one method for calculating the waveform symmetry parameter $K_{max}$ by way of example. The method used for calculating the waveform symmetry parameter will vary depending on the waveform symmetry recognition method used. For instance, in the above example in which waveform distortion is assessed on the basis of the proportion made up by a high-frequency component, the waveform symmetry parameter $k_{max}$ may also be $\frac{Max(I_{2a}, I_{2b}, I_{2c})}{Max(I_{1a}, I_{1b}, I_{1c})}$, where $I_2$ is the second harmonic component and $I_1$ is the fundamental wave component. Of course, in Formula (4) of this embodiment, only the difference values of the currents have been used, without taking into account the second harmonic component.

In step S260, it is determined whether $k_{max}$ is greater than a predetermined threshold $K_{asmy}$. If $k_{max} \geq K_{asmy}$, then the waveform is asymmetric, otherwise the waveform is symmetric, i.e. is not a magnetizing inrush current. Here, $K_{asmy}$ can be set on the basis of empirical values. $K_{asmy}$ is set as any suitable non-zero value according to actual requirements. In this embodiment, the value of $K_{asmy}$ is preferably 0.2 - 0.8, even more preferably 0.3 - 0.4. $K_{asmy}$ may be determined by a number of methods. For example, the maximum value of the ratio $k_{max}$ may be calculated by varying the phase angle at switch-on with no load, using a simulation model; this value can then be taken as the upper limit of

$K_{asmy}$. Next, various internal transformer faults are simulated and calculations carried out thereon, to verify whether the chosen value of $K_{asmy}$ meets the requirements.

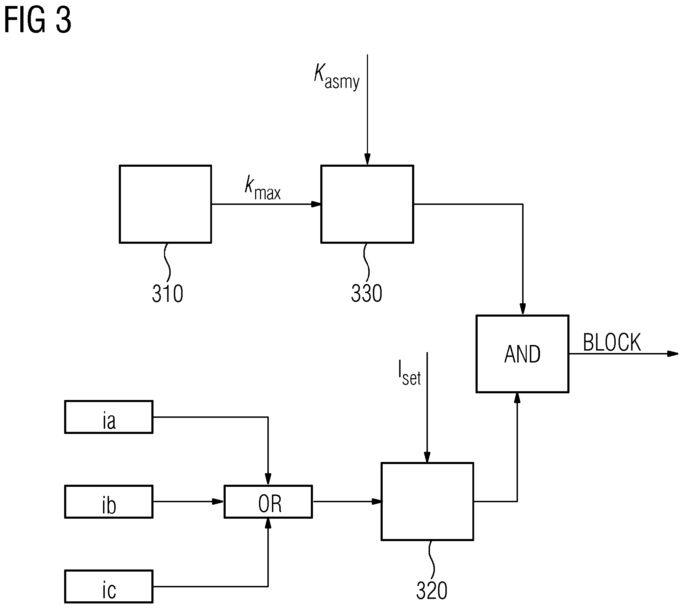

Fig. 3 shows by way of example a logic diagram for realizing inrush current restraint on the basis of the inrush current detection method shown in Fig. 2. As Fig. 3 shows, preferably, it is determined whether the current of at least one of the three phases is greater than a given current threshold $I_{set}$. $I_{set}$ is preferably $0.1*I_N$ - $0.3*I_N$, for instance, where $I_N$ is the rated current of the transformer. If the current of any phase is greater than $I_{set}$ and the waveform asymmetry condition ($k_{max} > K_{asmy}$) is satisfied, this indicates a magnetizing inrush current, so that a blocking signal BLOCK is emitted to block the action of differential protection. The logic diagram shown in Fig. 3 gives details. As Fig. 3 shows, the detected currents $i_a$, $i_b$ and $i_c$ of the three phases are sent into a comparator 320 via an OR logic device, for comparison with $I_{set}$. The comparison result of comparator 320 is outputted to an AND logic device. At the same time, the waveform symmetry parameter $k_{max}$ is calculated in module 310 by the method shown in Fig. 2. The waveform symmetry parameter $k_{max}$ calculated is sent into a comparator 330 for comparison with the threshold $K_{asmy}$. The comparison result of comparator 330 is delivered to the AND logic device. If both inputs of the AND logic device are effective, i.e. $k_{max} \geq K_{asmy}$ and the current of at least one phase is greater than $I_{set}$, then the AND logic device outputs an effective blocking signal BLOCK which can be used to block the differential protection of the transformer. Hence instantaneous tripping of the transformer due to the occurrence of a magnetizing inrush current when it is switched on with no load can be avoided. In the example shown in Fig. 3, the comparators 320 and 330 are preferably comparators with hysteresis.

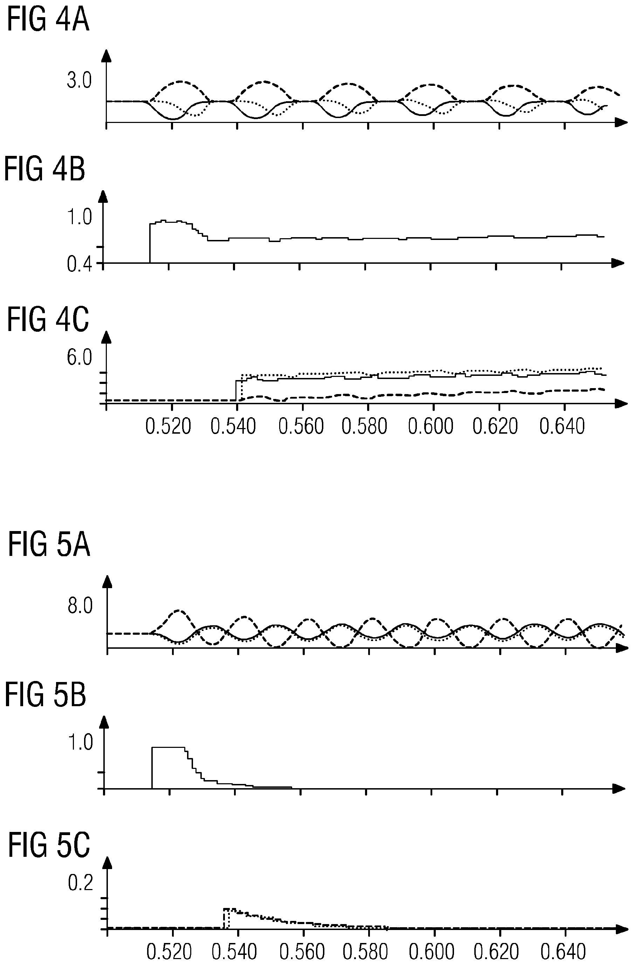

Figs. 4A - C and Figs. 5A - C show by way of example the waveforms, waveform symmetry parameters $k_{max}$ and proportions made up by the second harmonic component of a magnetizing inrush current and fault current, respectively. Fig. 4A shows the current waveform of a transformer when it is switched on with no load, wherein the proportion of one AC phase made up by the second harmonic is less than 15%, indicating the waveform of a magnetizing inrush current. It can be seen from Fig. 4A that the waveform of the magnetizing inrush current is asymmetric in at least two phases. Fig. 4B shows the waveform symmetry parameter $k_{max}$ calculated on the basis of the sampled difference currents shown in Fig. 4A by the method shown in Fig. 2. As Fig. 4B shows, $k_{max}$ has a value greater than 0.4. Fig. 4C shows the proportions of the magnetizing inrush current made up by the second harmonic. As Fig. 4C shows, the proportion of one AC phase made up by the second harmonic is less than 15%. In other words, if a judgment is made on whether a magnetizing inrush current has occurred solely on the basis of whether the proportion made up by the second harmonic is less than 15%, then an erroneous judgment is likely, but Fig. 4A can be correctly determined as showing a magnetizing inrush current by the recognition method based on the waveform symmetry parameter $k_{max}$. Hence differential protection of the transformer can be further blocked, so that it operates normally.

Fig. 5A shows the current waveform of a transformer when it is switched on with no load, wherein a short circuit fault has occurred in phases b and c on the secondary side. It can be seen from Fig. 5A that the waveform of the fault current is substantially symmetric. Fig. 5B shows the waveform symmetry parameter $k_{max}$ calculated on the basis of the sampled currents shown in Fig. 5A by the method shown in Fig. 2. As Fig. 5B shows, $k_{max}$ rapidly falls to less than 0.3 after one cycle. In other words, if $K_{asmy}$ is set at approximately 0.3, then once the distinguishing process has begun, a fault current can be correctly distinguished after one period. Fig. 5C shows the proportions of the fault current made up by the second harmonic. As Fig. 5C shows, the proportion made up by the second harmonic only falls below 15% after 2 periods have elapsed since the occurrence of the fault. When Fig. 5B is compared with Fig. 5C, it can be seen that by using the detection method proposed in the present invention, a correct judgment can be made within a shorter time, so that differential protection of the transformer is activated promptly and accurately.

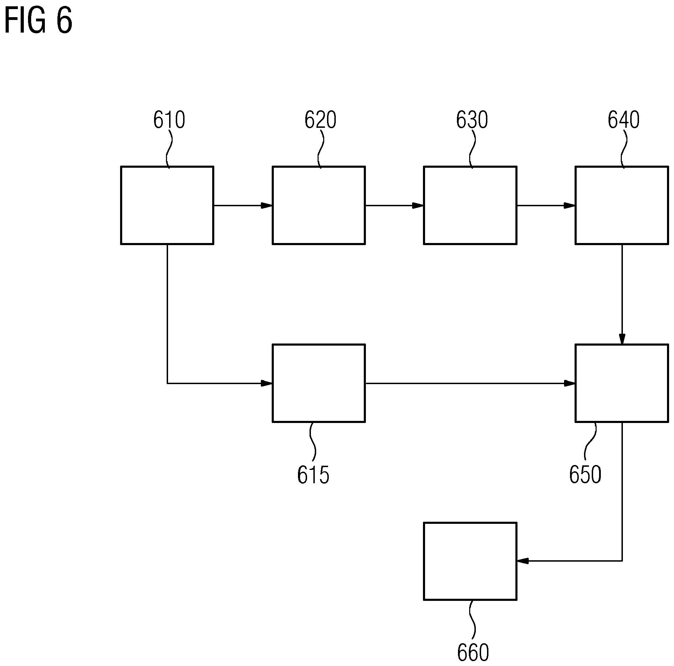

The method and logic shown in Figs. 2 and 3 above can be realized using software, hardware, or a combination of software and hardware. Fig. 6 is a block diagram of the hardware structure of one embodiment realized using hardware. As Fig. 6 shows, the device for transformer protection comprises: an acquisition unit 610, a first judgment unit 615, a factor calculation unit 620, a maximum value determination unit 630, a symmetry parameter acquisition unit 640, a second judgment unit 650 and a blocking signal generating unit 660. Preferably, the factor calculation unit 620 further comprises a filter unit 621.

As Fig. 6 shows, the acquisition unit 610 samples a current $i_x(n)$ for each AC phase of a transformer, and sends these currents into the first judgment unit 615 and the factor calculation unit 620. The first judgment unit 615 determines whether the current $i_x(n)$ of any one of the three AC phases exceeds a predetermined current threshold. For each AC phase, the factor calculation unit 620 calculates factors Ax and Bx for waveform symmetry recognition, on the basis of currents sampled within one period. For each type of factor (Ax or Bx), the maximum value determination unit 630 obtains the maximum value of the three factors corresponding to the three AC phases, to serve as a maximum phase factor (Amax, Bmax) of that factor. The symmetry parameter acquisition unit 640 calculates a corresponding waveform symmetry parameter $k_{max}$, on the basis of the maximum phase factor (Amax, Bmax) obtained. The judgment unit 650 determines that a magnetizing inrush current has not occurred if the waveform symmetry parameter $k_{max}$ meets the waveform symmetry requirement; in turn, if the judgment result of the judgment unit 650 is that the waveform is asymmetric and the judgment result of the first judgment unit is that the current of at least one AC phase exceeds the predetermined threshold, then it is determined that a magnetizing inrush current has occurred. The blocking unit 660 blocks differential protection of the transformer when the judgment unit 650 determines that a magnetizing inrush current has occurred.

The various units shown in Fig. 6 may be realized using computing circuits in the form of hardware; they may also be realized using an FPGA, DSP, embeddable programmed microprocessors, or microcontrollers, etc. For instance, the judgment circuit may be realized using a comparator, preferably a comparator with hysteresis. The symmetry parameter acquisition unit may be realized using a divider circuit based on an op-amp, etc. All these solutions are obvious to those skilled in the art.

Those skilled in the art should appreciate that various changes and amendments could be made to the embodiments disclosed above without departing from the substance of the present invention; all such changes and amendments should fall within the scope of protection of the present invention. Therefore, the scope of protection of the present invention should be defined by the attached claims.

**Claims**

1. A magnetizing inrush current detection method for a transformer, comprising:

sampling (S210) currents to obtain sampled current values ($i_x(n)$) for each AC phase a, b, c of the transformer; and determining whether the sampled current value ($i_x(n)$) of any one of the AC phases exceeds a predetermined current threshold ($I_{set}$);
the method being **characterized by**
determining (S220), for each phase, difference currents ($i_x'(n)$) based on the sampled current value at a sampling point ($i_x(n)$) and the sampled current value at a sampling point spaced therefrom ($i_x(n-M)$), e.g. $i_x'(n) = i_x(n) - i_x(n-1)$;
calculating (S230), for each AC phase, at least two types of factors ($A_x(n)$, $B_x(n)$; $A_x$, $B_x$; $A_a$, $A_b$, $A_c$; $B_a$, $B_b$, $B_c$) for waveform symmetry recognition, on the basis of the difference currents ($i_x'(n)$) calculated within one one period;
for each type of factor ($A_x$, $B_x$; $A_a$, $A_b$, $A_c$; $B_a$, $B_b$, $B_c$), obtaining (S240) the maximum value ($A_{max}$, $B_{max}$) of the factors of the same type ($A_a$, $A_b$, $A_c$; $B_a$, $B_b$, $B_c$) corresponding to the AC phases, to serve as a maximum phase factor ($A_{max}$, $B_{max}$) of that type of factor;
based on the maximum phase factors obtained, using (S250) a waveform symmetry recognition algorithm to calculate a corresponding waveform symmetry parameter ($k_{max}$);
if the waveform symmetry parameter ($k_{max}$) meets a requirement for waveform asymmetry ($k_{max} >= K_{asmy}$) and the current $i_x(n)$ of any AC phase exceeds the predetermined current threshold ($I_{set}$), then determining (S260) that a magnetizing inrush current has occurred.

2. The method as claimed in claim 1, wherein the factors used for waveform symmetry recognition comprise:

a first factor ($A_x$), which is a function

$$f\left(i_x'(n) + i_x'\left(n - \frac{N}{2}\right)\right)$$

of the sum of two difference current values

$$\left(i_x'(n), i_x'\left(n - \frac{N}{2}\right)\right)$$

separated by half a period;
a second factor ($B_x$), which is a function

$$f\left(i_x'(n) - i_x'\left(n - \frac{N}{2}\right)\right)$$

of the difference between two difference current values

$$(i'_x(n), i'_x\left(n - \frac{N}{2}\right))$$

separated by half a period.

3. The method as claimed in claim 2, wherein

the function used for the first factor ($A_x$) is the cumulative value

$$f\left(i'_x(n) + i'_x\left(n - \frac{N}{2}\right)\right) = \sum_{n=0}^{N/2-1} |i'_x(n) + i'_x\left(n - \frac{N}{2}\right)|$$

of the modulus of said sum over half a period;
the function used for the second factor ($B_x$) is the cumulative value

$$f\left(i'_x(n) - i'_x\left(n - \frac{N}{2}\right)\right) = \sum_{n=0}^{N/2-1} |i'_x(n) - i'_x\left(n - \frac{N}{2}\right)|$$

of the modulus of said difference over half a period.

4. The method as claimed in any one of claims 1 to 3, wherein
the waveform symmetry parameter ($k_{max}$) is the maximum phase factor of the first factor ($A_x$) divided by the maximum phase factor of the second factor ($B_x$).

5. The method as claimed in claim 1, wherein the difference current value ($i'_x(n)$) is found by a forward difference method.

6. A magnetizing inrush current restraint method for a transformer, comprising:

determining, by the method as claimed in any one of claims 1-5, whether the current flowing through the transformer at the present time is a magnetizing inrush current;
if it is a magnetizing inrush current, then blocking differential protection of the transformer.

7. A device for transformer protection, comprising:

an acquisition unit (610), for sampling for each AC phase a, b, c the currents flowing through the transformer to obtain sampled current values ($i_x(n)$); and
a first judgment unit (615), for determining whether the sampled current value ($i_x(n)$) of any one of the AC phases exceeds a predetermined current threshold ($I_{set}$),
the device being **characterized by**
means for determining (S220), for each phase, difference currents ($i_x'(n)$) given by the difference between the sampled current value at a sampling point ($i_x(n)$) and the sampled current value at a sampling point spaced therefrom ($i_x(n-M)$);
a factor calculation unit (620), for calculating at least two types of factors ($A_x(n)$, $B_x(n)$; $A_a$, $A_b$, $A_c$; $B_a$, $B_b$, $B_c$) for waveform symmetry recognition for each AC phase, on the basis of the difference currents ($i_x'(n)$) sampled within one period;
a maximum value determination unit (630), for obtaining the maximum value ($A_{max}$, $B_{max}$) of the factors of the same type ($A_a$, $A_b$, $A_c$; $B_a$, $B_b$, $B_c$) corresponding to the AC phases for each type of factor, to serve as a maximum phase factor ($A_{max}$, $B_{max}$) of that factor;
a symmetry parameter acquisition unit (640), for calculating a corresponding waveform symmetry parameter ($k_{max}$) according to said waveform symmetry recognition, based on the maximum phase factor obtained ($A_{max}$, $B_{max}$);
a second judgment unit (650), for determining that a magnetizing inrush current has occurred if the waveform symmetry parameter ($k_{max}$) meets the requirement for waveform asymmetry ($k_{max} >= K_{asmy}$) and the first judgment unit (615) gives a positive result.

8. The device as claimed in claim 7, wherein
the factors used for waveform symmetry recognition comprise:

a first factor ($A_x$), which is the cumulative sum over an entire half-cycle of the sum of two difference current values ($i_x'(n)$) separated by half a period;
a second factor ($B_x$), which is the cumulative sum over an entire half-cycle of the difference between two difference current values ($i_x'(n)$) separated by half a period.

9. The device as claimed in claim 7, further comprising:
a blocking unit (660), for blocking differential protection of the transformer when the judgment unit determines that a magnetizing inrush current has occurred.

10. A device for transformer protection, comprising:

a microprocessor, for performing operations or processing according to commands;
a memory, for storing commands which can be executed by the microprocessor, the commands being used to realize the method as claimed in any one of claims 1 to 6 when executed by the microprocessor.

11. A computer program product, comprising:
code which can be executed by a machine, the code being used to realize the method as claimed in any one of claims 1 to 6 when executed by the machine.

12. A computer recording medium, comprising:
a machine-recordable/readable medium on which machine-executable code is stored, the code being used to realize the method as claimed in any one of claims 1 to 6 when executed by a machine.

**Patentansprüche**

1. Verfahren zum Erkennen eines Magnetisierungseinschaltstroms für einen Transformator, umfassend:

Abtasten (S210) von Strömen, um abgetastete Stromwerte ($i_x(n)$) für jede AC-Phase a, b, c des Transformators zu erhalten; und Ermitteln, ob der abgetastete Stromwert ($i_x(n)$) von einer der AC-Phasen einen vorbestimmten Stromschwellenwert ($I_{set}$) überschreitet;
wobei das Verfahren **gekennzeichnet ist durch**:

Ermitteln (S220), für jede Phase, von Differenzströmen ($i_x'(n)$) aufgrund des abgetasteten Stromwerts an einem Abtastpunkt ($i_x(n)$) und des abgetasteten Stromwerts an einem davon beabstandeten Abtastpunkt ($i_x(n - M)$), Z.B. $i_x'(n) = i_x(n) - i_x(n - 1)$;
Berechnen (S230), für jede AC-Phase, von mindestens zwei Typen von Faktoren ($A_x(n)$, $B_x(n)$; $A_x$, $B_x$; $A_a$, $A_b$, $A_c$; $B_a$, $B_b$, $B_c$) für eine Wellenformsymmetrieerkennung auf der Grundlage der Differenzströme ($i_x'(n)$), die in einer Periode berechnet werden;
für jeden Faktortyp ($A_x$, $B_x$; $A_a$, $A_b$, $A_c$; $B_a$, $B_b$, $B_c$), Erhalten (S240) des Maximalwerts ($A_{max}$, $B_{max}$) der Faktoren des gleichen Typs ($A_a$, $A_b$, $A_c$; $B_a$, $B_b$, $B_c$), der den AC-Phasen entspricht, um als ein maximaler Phasenfaktor ($A_{max}$, $B_{max}$) dieses Faktortyps zu dienen;
aufgrund der erhaltenen maximalen Phasenfaktoren, Verwenden (S250) eines Wellenformsymmetrieerkennungsalgorithmus zum Berechnen eines entsprechenden Wellenformsymmetrieparameters ($k_{max}$);
wenn der Wellenformsymmetrieparameter ($k_{max}$) eine Anforderung für eine Wellenformasymmetrie ($k_{max} >= K_{asmy}$) erfüllt und der Strom $i_x(n)$ von einer beliebigen AC-Phase den vorbestimmten Stromschwellenwert ($I_{set}$) überschreitet, Ermitteln (S260), dass ein Magnetisierungseinschaltstrom aufgetreten ist.

2. Verfahren nach Anspruch 1, wobei die Faktoren, die für eine Wellenformsymmetrieerkennung verwendet werden, umfassen:

einen ersten Faktor ($A_x$), der eine Funktion

$$f(i'_x(n) + i'_x\left(n - \frac{N}{2}\right))$$

der Summe von zwei Differenzstromwerten ist:

$$\left(i'_x(n), i'_x\left(n - \frac{N}{2}\right)\right) \quad ,$$

die durch eine halbe Periode getrennt sind; einen zweiten Faktor ($B_x$), der eine Funktion

$$f(i'_x(n) - i'_x\left(n - \frac{N}{2}\right))$$

der Differenz zwischen zwei Differenzstromwerten ist:

$$\left(i'_x(n), i'_x\left(n - \frac{N}{2}\right)\right),$$

die durch eine halbe Periode getrennt sind.

3. Verfahren nach Anspruch 2, wobei
die Funktion, die für den ersten Faktor ($A_x$) verwendet wird, der kumulative Wert

$$f\left(i'_x(n) - i'_x\left(n - \frac{N}{2}\right)\right) = \sum_{n=0}^{\frac{N}{2}-1} \left|i'_x(n) - i'_x\left(n - \frac{N}{2}\right)\right|$$

des Betrags der Summe über eine halbe Periode ist;
die Funktion, die für den zweiten Faktor ($B_x$) verwendet wird, der kumulative Wert

$$f\left(i'_x(n) - i'_x\left(n - \frac{N}{2}\right)\right) = \sum_{n=0}^{\frac{N}{2}-1} \left|i'_x(n) - i'_x\left(n - \frac{N}{2}\right)\right|$$

des Betrags der Differenz über eine halbe Periode ist.

4. Verfahren nach einem der Ansprüche 1 bis 3, wobei der Wellenformsymmetrieparameter ($k_{max}$) der maximale Phasenfaktor des ersten Faktors ($A_x$) dividiert durch den maximalen Phasenfaktor des zweiten Faktors ($B_x$) ist.

5. Verfahren nach Anspruch 1, wobei der Differenzstromwert ($i'_x$ (n)) durch ein Vorwärtsdifferenzverfahren gefunden wird.

6. Verfahren zum Beschränken eines Magnetisierungseinschaltstroms für einen Transformator, umfassend:

Ermitteln, durch das Verfahren nach einem der Ansprüche 1 bis 5, ob der Strom, der gegenwärtig durch den Transformator fließt, ein Magnetisierungseinschaltstrom ist;
wenn es ein Magnetisierungseinschaltstrom, Blockieren eines differenziellen Schutzes des Transformators.

7. Vorrichtung zum Schützen eines Transformators, umfassend:

eine Erfassungseinheit (610) zum Abtasten, für jede AC-Phase a, b, c, der Ströme, die durch den Transformator fließen, um abgetastete Stromwerte ($i_x(n)$) zu erhalten; und

eine erste Beurteilungseinheit (615) zum Ermitteln, ob der abgetastete Stromwert ($i_x(n)$) von einer der AC-Phasen einen vorbestimmten Stromschwellenwert ($I_{set}$) überschreitet,

wobei die Vorrichtung **gekennzeichnet ist durch**

ein Element zum Ermitteln (S220), für jede Phase, von Differenzströmen ($i_x'(n)$), die durch die Differenz zwischen dem abgetasteten Stromwert an einem Abtastpunkt ($i_x(n)$) und dem abgetasteten Stromwert an einem davon beabstandeten Abtastpunkt ($i_x(n - M)$) gegeben sind;

eine Faktorberechnungseinheit (620) zum Berechnen von mindestens zwei Typen von Faktoren ($A_x(n)$, $B_x(n)$; $A_a$, $A_b$, $A_c$; $B_a$, $B_b$, $B_c$) für eine Wellenformsymmetrieerkennung für jede AC-Phase auf der Grundlage der Differenzströme ($i_x'(n)$), die in einer Periode abgetastet werden;

eine Maximalwertermittlungseinheit (630) zum Erhalten des Maximalwerts ($A_{max}$, $B_{max}$) der Faktoren des gleichen Typs ($A_a$, $A_b$, $A_c$; $B_a$, $B_b$, $B_c$), die den AC-Phasen für jeden Faktortyp entsprechen, um als ein maximaler Phasenfaktor ($A_{max}$, $B_{max}$) dieses Faktors zu dienen;

eine Symmetrieparametererfassungseinheit (640) zum Berechnen eines entsprechenden Wellenformsymmetrieparameters ($k_{max}$) gemäß der Wellenformsymmetrieerkennung aufgrund des erhaltenen maximalen Phasenfaktors ($A_{max}$, $B_{max}$);

eine zweite Beurteilungseinheit (650) zum Ermitteln, dass ein Magnetisierungseinschaltstrom aufgetreten ist, wenn der Wellenformsymmetrieparameter ($k_{max}$) die Anforderung für eine Wellenformasymmetrie ($k_{max} >= K_{asmy}$) erfüllt und die erste Beurteilungseinheit (615) ein positives Ergebnis ausgibt.

8. Vorrichtung nach Anspruch 7, wobei
die Faktoren, die für eine Wellenformsymmetrieerkennung verwendet werden, umfassen:

einen ersten Faktor ($A_x$), der die kumulative Summe über einen vollständigen Halbzyklus der Summe von zwei Differenzstromwerten ($i_x'(n)$) ist, die durch eine halbe Periode getrennt sind;

einen zweiten Faktor ($B_x$), der die kumulative Summe über einen vollständigen Halbzyklus der Differenz zwischen zwei Differenzstromwerten ($i_x'(n)$) ist, die durch eine halbe Periode getrennt sind.

9. Vorrichtung nach Anspruch 7, das außerdem umfasst:
eine Blockiereinheit (660) zum Blockieren eines differenziellen Schutzes des Transformators, wenn die Beurteilungseinheit ermittelt, dass ein Magnetisierungseinschaltstrom aufgetreten ist.

10. Vorrichtung zum Schützen eines Transformators, umfassend:

einen Mikroprozessor zum Ausführen von Operationen oder Verarbeiten gemäß Befehlen;

einen Speicher zum Speichern von Befehlen, die durch den Mikroprozessor ausgeführt werden können, wobei die Befehle verwendet werden, um das Verfahren nach einem der Ansprüche 1 bis 6 umzusetzen, wenn sie von dem Mikroprozessor ausgeführt werden.

11. Computerprogrammprodukt, umfassend:
einen Code, der von einer Maschine ausgeführt werden kann, wobei der Code verwendet wird, um das Verfahren nach einem der Ansprüche 1 bis 6 umzusetzen, wenn er von der Maschine ausgeführt wird.

12. Computerbeschreibbares Medium, umfassend:
einen maschinenbeschreibbares/-lesbares Medium, in dem ein maschinenausführbarer Code gespeichert ist, wobei der Code verwendet wird, um das Verfahren nach einem der Ansprüche 1 bis 6 umzusetzen, wenn er von einer Maschine ausgeführt wird.

**Revendications**

1. Procédé de détection d'un courant d'appel magnétisant pour un transformateur, comprenant les étapes consistant à :

échantillonner (S210) des courants pour obtenir des valeurs de courant échantillonné ($i_x(n)$) pour chaque phase de CA a, b, c du transformateur ; et

déterminer si la valeur de courant échantillonné ($i_x(n)$) d'une des phases de CA dépasse un seuil de courant prédéterminé ($I_{set}$) ;

le procédé étant **caractérisé par** les étapes consistant à déterminer (S220), pour chaque phase, des courants de différence ($i_x'(n)$) sur la base de la valeur de courant échantillonné à un point d'échantillonnage ($i_x(n)$) et de la valeur de courant échantillonné à un point d'échantillonnage espacé de celui-ci ($i_x(n-M)$), par exemple $i_x'(n)$ = $i_x(n) - i_x(n-1)$ ;

calculer (S230), pour chaque phase de CA, au moins deux types de facteurs ($A_x(n)$, $B_x(n)$ ; $A_x$, $B_x$ ; $A_a$, $A_b$, $A_c$ ; $B_a$, $B_b$, $B_c$) pour une reconnaissance de symétrie de forme d'onde, sur la base des courants de différence ($i_x'(n)$) calculés à l'intérieur d'une seule période ;

pour chaque type de facteur ($A_x$, $B_x$ ; $A_a$, $A_b$, $A_c$ ; $B_a$, $B_b$, $B_c$), obtenir (S240) la valeur maximale ($A_{max}$, $B_{max}$) des facteurs du même type ($A_a$, $A_b$, $A_c$ ; $B_a$, $B_b$, $B_c$) correspondant aux phases de CA, afin de servir de facteur de phase maximal ($A_{max}$, $B_{max}$) de ce type de facteur ;

sur la base des facteurs de phase maximaux obtenus, utiliser (S250) un algorithme de reconnaissance de symétrie de forme d'onde pour calculer un paramètre de symétrie de forme d'onde correspondant ($k_{max}$) ;

si le paramètre de symétrie de forme d'onde ($k_{max}$) répond à une condition pour une asymétrie de forme d'onde $k_{max} >= K_{asmy}$) et le courant $i_x(n)$ d'une phase CA dépasse le seuil de courant prédéterminé ($I_{set}$), alors déterminer (S260) qu'un courant d'appel magnétisant est survenu.

2. Procédé selon la revendication 1, dans lequel les facteurs utilisés pour la reconnaissance de symétrie de forme d'onde comprennent :

un premier facteur ($A_x$), qui est une fonction

$$f\left(i_x'(n) + i_x'\left(n - \frac{N}{2}\right)\right)$$

de la somme de deux valeurs de courant de différence

$$\left(i_x'(n), i_x'\left(n - \frac{N}{2}\right)\right)$$

séparées d'une demi-période ;
un deuxième facteur ($B_x$), qui est une fonction

$$f\left(i_x'(n) - i_x'\left(n - \frac{N}{2}\right)\right)$$

de la différence entre deux valeurs de courant de différence

$$\left(i_x'(n), i_x'\left(n - \frac{N}{2}\right)\right)$$

séparées d'une demi-période.

3. Procédé selon la revendication 2, dans lequel la fonction utilisée pour le premier facteur ($A_x$) est la valeur cumulée

$$f\left(i_x'(n) + i_x'\left(n - \frac{N}{2}\right)\right) = \sum_{n=0}^{N/2-1} \left|i_x'(n) + i_x'\left(n - \frac{N}{2}\right)\right|$$

du module de ladite somme sur une demi-période ;
la fonction utilisée pour le deuxième facteur ($B_x$) est la valeur cumulée

$$f\left(i'_x(n) - i'_x\left(n - \frac{N}{2}\right)\right) = \sum_{n=0}^{N/2-1} \left| i'_x(n) - i'_x\left(n - \frac{N}{2}\right)\right|$$

du module de ladite différence sur une demi-période.

4. Procédé selon l'une quelconque des revendications 1 à 3, dans lequel le paramètre de symétrie de forme d'onde ($k_{max}$) est le facteur de phase maximal du premier facteur ($A_x$) divisé par le facteur de phase maximal du deuxième facteur ($B_x$).

5. Procédé selon la revendication 1, dans lequel la valeur de courant de différence ($i'_x(n)$) est trouvée par un procédé de différence directe.

6. Procédé de restriction d'un courant d'appel magnétisant pour un transformateur, comprenant les étapes consistant à :

déterminer, par le procédé selon l'une quelconque des revendications 1 à 5, si le courant passant par le transformateur à l'instant présent est un courant d'appel magnétisant ;
s'il s'agit d'un courant d'appel magnétisant, alors bloquer la protection différentielle du transformateur.

7. Dispositif pour la protection d'un transformateur, comprenant :

une unité d'acquisition (610), destinée à échantillonner pour chaque phase de CA a, b, c les courants passant par le transformateur afin d'obtenir des valeurs de courant échantillonné ($i_x(n)$) ; et
une première unité d'évaluation (615), destinée à déterminer si la valeur de courant échantillonné ($i_x(n)$) d'une des phases de CA dépasse un seuil de courant prédéterminé ($I_{set}$),
le dispositif étant **caractérisé par**
des moyens pour déterminer (S220), pour chaque phase, des courants de différence ($i_x'(n)$) donnés par la différence entre la valeur de courant échantillonné à un point d'échantillonnage ($i_x(n)$) et la valeur de courant échantillonné à un point d'échantillonnage espacé de celui-ci ($i_x(n-M)$) ;
une unité de calcul de facteur (620), destinée à calculer au moins deux types de facteurs ($A_x(n)$, $B_x(n)$ ; $A_a$, $A_b$, $A_c$ ; $B_a$, $B_b$, $B_c$) pour la reconnaissance de symétrie de forme d'onde pour chaque phase de CA, sur la base des courants de différence ($i_x'(n)$) échantillonnés à l'intérieur d'une seule période ;
une unité de détermination de valeur maximale (630), destinée à obtenir la valeur maximale ($A_{max}$, $B_{max}$) des facteurs du même type ($A_a$, $A_b$, $A_c$ ; $B_a$, $B_b$, $B_c$) correspondant aux phases de CA pour chaque type de facteur, afin de servir de facteur de phase maximal ($A_{max}$, $B_{max}$) de ce facteur ;
une unité d'acquisition de paramètre de symétrie (640), destinée à calculer un paramètre de symétrie de forme d'onde correspondant ($k_{max}$) selon la reconnaissance de symétrie de forme d'onde, sur la base du facteur de phase maximal obtenu ($A_{max}$, $B_{max}$) ;
une deuxième unité d'évaluation (650), destinée à déterminer qu'un courant d'appel magnétisant est survenu si le paramètre de symétrie de forme d'onde ($k_{max}$) répond à la condition d'une asymétrie de forme d'onde ($k_{max} >= K_{asmy}$) et la première unité d'évaluation (615) donne un résultat positif.

8. Dispositif selon la revendication 7, dans lequel les facteurs utilisés pour la reconnaissance de symétrie de forme d'onde comprennent:

un premier facteur ($A_x$), qui est la somme cumulée sur un demi-cycle entier de la somme de deux valeurs de courant de différence ($i_x'(n)$) séparées d'une demi-période ;
un deuxième facteur ($B_x$), qui est la somme cumulée sur un demi-cycle entier de la différence entre deux valeurs de courant de différence ($i_x'(n)$) séparées d'une demi-période.

9. Dispositif selon la revendication 7, comprenant en outre :
une unité de blocage (660), pour bloquer la protection différentielle du transformateur lorsque l'unité d'évaluation détermine qu'un courant d'appel magnétisant est survenu.

10. Dispositif pour la protection d'un transformateur, comprenant :

un microprocesseur, pour effectuer des opérations ou un traitement selon des ordres ;

une mémoire, pour stocker des ordres qui peuvent être exécutés par le microprocesseur, les ordres étant utilisés pour réaliser le procédé selon l'une quelconque des revendications 1 à 6 lorsqu'ils sont exécutés par le microprocesseur.

11. Produit de programme informatique, comprenant :
du code qui peut être exécuté par une machine, le code étant utilisé pour réaliser le procédé selon l'une quelconque des revendications 1 à 6 lorsqu'il est exécuté par la machine.

12. Support d'enregistrement informatique, comprenant :
un support inscriptible/lisible par machine, sur lequel est stocké du code exécutable par machine, le code étant utilisé pour réaliser le procédé selon l'une quelconque des revendications 1 à 6 lorsqu'il est exécuté par une machine.

FIG 1A

FIG 1B

FIG 1C

# FIG 2

```
┌─────────────────────┐
│   Sampling and      │── S210
│   obtaining i_X(n)  │
└─────────────────────┘
          │
┌─────────────────────┐
│  Obtaining i'_X(n)  │── S220
└─────────────────────┘
          │
┌─────────────────────┐
│  Calculating Ax, Bx │── S230
└─────────────────────┘
          │
┌─────────────────────┐
│ Finding the maximum │── S240
│    phase factor     │
└─────────────────────┘
          │
┌─────────────────────┐
│  Calculating k_max  │── S250
└─────────────────────┘
          │
    ◇ k_max ≥ K_asmy ? ◇── N ──→
          │ Y      S260
       Rush
      Current
```

$k_{max} \geq K_{asmy}$ ?

## FIG 3

$$K_{asmy}$$

$$k_{max}$$

310

330

$$I_{set}$$

AND — BLOCK

ia

ib — OR

ic

320

FIG 4A

FIG 4B

FIG 4C

FIG 5A

FIG 5B

FIG 5C

FIG 6

**EP 2 891 216 B1**

**REFERENCES CITED IN THE DESCRIPTION**

**Patent documents cited in the description**

- CN 1182297 A

- US 3657605 A